# EUROPEAN PATENT APPLICATION

(11) **EP 4 340 022 A1**
(43) Date of publication of application: **20.03.2024**
(21) Application number: 23197018.7
(22) Date of filing: 12.09.2023
(51) Int. Cl.: H01L 23/495, H01L 23/31

(54) **PACKAGE STRUCTURE FOR ASYMMETRIC TRANSIENT VOLTAGE SUPPRESSOR**

(30) Priority: 16.09.2022 CN 202211129283
(71) Applicant: Littelfuse Semiconductor (Wuxi) Co., Ltd., Wuxi, Jiangsu 214142 (CN)
(72) Inventor: Zhang, Lucas, Wuxi, 214142 (CN); Gao, Chao, Wuxi, 214142 (CN); He, Lei, Wuxi, 214142 (CN)
(74) Representative: Arnold & Siedsma

(57) **Abstract**

A surface mounting apparatus, structure, and associated methods thereof. The surface mounting apparatus includes a housing, a lead frame, at least partially encapsulated by the housing. The lead frame includes a chip mounting surface having a chip mounting pad, and one or more first stress relief features disposed outside of the chip mounting surface. The apparatus further includes another lead frame, at least partially encapsulated by the housing. The other lead frame includes one or more second stress relief features

## Description

### TECHNICAL FIELD

This disclosure relates generally to the field of power semiconductor discrete devices, and in particular, to surface mounting packages, including package structures for asymmetric transient voltage suppressor devices.

### BACKGROUND

Packaging an integrated circuit is typically a final stage of a semiconductor device fabrication process. During packaging, a semiconductor die, which represents the core of a semiconductor device, is encased in a housing that protects the die against physical damage and corrosion. For example, semiconductor dies are commonly mounted on a copper substrate, using solder alloy reflow, conductive epoxy, etc. The mounted semiconductor die is often then encapsulated within a plastic or epoxy compound.

Transient voltage suppressor (TVS) devices represent an important branch of power semiconductor devices that can be used to protect sensitive electronic equipment from voltage transients, e.g., lighting and/or other transient voltage events. Currently, TVS device packaging is typically characterized by a small size and higher power. An example of TVS device packaging includes a surface mounting C type (SMC) packaging that is used in many different technological areas, e.g., in multi-point data transmission systems. Typically, multi-point data transmission systems require use of asymmetric TVS devices, where SMC packaging provides protection of electronic components in a printed circuit board from electrostatic discharge (ESD), electrical fast transients (EFT), lightning, etc. However, current SMC packaging of TVS devices are deficient in addressing different heat dissipation requirements, different manufacturing process features, etc. as well as other electronic components and/or systems requirements.

### SUMMARY

In some implementations, the current subject matter relates to a surface mounting structure and/or apparatus. The structure may include a housing, a lead frame, at least partially encapsulated by the housing, where the lead frame may include a chip mounting surface having a chip mounting pad, and one or more first stress relief features disposed outside of the chip mounting surface. The structure may also include another lead frame, at least partially encapsulated by the housing, where the other lead frame may include one or more second stress relief features.

In some implementations, the current subject matter may include one or more of the following optional features. In some implementations, a semiconductor chip may be configured to be coupled to the chip mounting pad. Upon coupling of the semiconductor chip to the chip mounting pad, the chip mounting surface does not contact the semiconductor chip.

In some implementations, the current subject matter's structure may also include a clip fully encapsulated by the housing, wherein the other lead frame may be configured to be coupled to the clip. The semiconductor chip may include a semiconductor chip working area. The clip may be configured to be coupled to the semiconductor chip working area. Moreover, the clip may be configured to include one or more support bars extending laterally away from one or more edges of the clip.

In some implementations, one or more second stress relief features may include one or more stress relief bars extending laterally away from the another lead frame.

In some implementations, the clip may be configured to have a curved structure, wherein at least a portion of the curved structure of the clip may be configured to extend away from the semiconductor chip.

In some implementations, the lead frame may include a slanted portion configured to angularly extend away from the chip mounting surface. The first stress relief features may be configured to be formed in the slanted portion. The first stress relief features may include at least one of the following: a stress relief opening, one or more stress relief grooves, and any combination thereof. One or more stress relief grooves may be configured to be formed symmetrically about the stress relief opening in the slanted portion of the lead frame.

In some implementations, the lead frame may include a lead frame terminal end and the other lead frame may include another lead frame terminal end. The lead frame terminal end and the other lead terminal frame end may be configured to be coupled to at least one of the following: a substrate, a printed circuit board, and any combination thereof.

In some implementations, the housing may be manufactured from at least one of the following: an epoxy compound, a plastic, and any combination thereof.

In some implementations, the apparatus may be configured to be a surface mounted apparatus. The apparatus may be configured to include a transient voltage suppression device.

In some implementations, the current subject matter relates to a method or an apparatus for manufacturing the apparatus discussed above. The method may include providing a semiconductor chip, forming one or more first stress relief features in a lead frame, the lead frame is configured to include a chip mounting pad disposed on a chip mounting surface of the lead frame, the one or more first stress relief features are configured to be formed outside of the chip mounting surface, coupling the lead frame to the semiconductor chip using the chip mounting pad, forming one or more second stress relief features in another lead frame; and forming a housing to encapsulate, the lead frame, the other lead frame, and the semiconductor chip, wherein at least a portion of each of the lead and the another lead frame is configured to extend outside of the housing.

In some implementations, the first stress relief features may include at least one of the following: one or more stress relief openings, one or more stress relief grooves, and any combination thereof. The second stress relief features may include one or more stress relief bars.

The details of one or more variations of the subject matter described herein are set forth in the accompanying drawings and the description below. Other features and advantages of the subject matter described herein will be apparent from the description and drawings, and from the claims.

### BRIEF DESCRIPTION OF THE DRAWINGS

The accompanying drawings, which are incorporated in and constitute a part of this specification, show certain aspects of the subject matter disclosed herein and, together with the description, help explain some of the principles associated with the disclosed implementations. In the drawings,
FIG. 1 illustrates an exemplary surface mount packaging structure, according to some implementations of the current subject matter;
FIG. 2 illustrates a top view of the structure shown in FIG. 1, according to some implementations of the current subject matter;
FIG. 3 illustrates a side view of the clip shown in FIG. 1, according to some implementations of the current subject matter;
FIG. 4 illustrates a top view of the clip shown in FIG. 3, according to some implementations of the current subject matter;
FIG. 5 illustrates a side view of the first and second leads shown in FIG. 1, according to some implementations of the current subject matter;
FIG. 6 illustrates a top view of the first and second leads shown in FIG. 5, according to some implementations of the current subject matter;
FIG. 7 illustrates a side view of a TVS chip;
FIG. 8 illustrates a top view of the TVS chip shown in FIG. 7;
FIG. 9 illustrates a bottom view of the TVS chip shown in FIG. 7; and
FIG. 10 illustrates an exemplary process, according to some implementations of the current subject matter.

The drawings are not necessarily to scale. The drawings are merely representations, not intended to portray specific parameters of the disclosure. The drawings are intended to depict exemplary implementations of the current subject matter, and therefore, are not to be considered as limiting in scope. In the drawings, like numbering represents like elements.

Further, certain elements in some of the figures may be omitted, and/or illustrated not-to-scale, for illustrative clarity. Cross-sectional views may be in the form of "slices", and/or "near-sighted" cross-sectional views, omitting certain background lines otherwise visible in a "true" cross-sectional view, for illustrative clarity. Additionally, for clarity, some reference numbers may be omitted in certain drawings.

### DETAILED DESCRIPTION

Various approaches in accordance with the present disclosure will now be described more fully hereinafter with reference to the accompanying drawings, where implementations of a system and method are shown. The devices, system(s), component(s), etc., may be embodied in many different forms and are not to be construed as being limited to the example implementations set forth herein. Instead, these example implementations are provided so this disclosure will be thorough and complete, and will fully convey the scope of the current subject matter to those skilled in the art.

To address these and potentially other deficiencies of currently available solutions, one or more implementations of the current subject matter relate to methods, systems, articles of manufacture, and the like that can, among other possible advantages, provide a packaging structure for asymmetric transient voltage suppressor devices, and in some example implementations, a surface mounted (e.g., A type (SMA), B type (SMB), C type (SMC), etc.) packaging structure for asymmetric transient voltage suppressor devices.

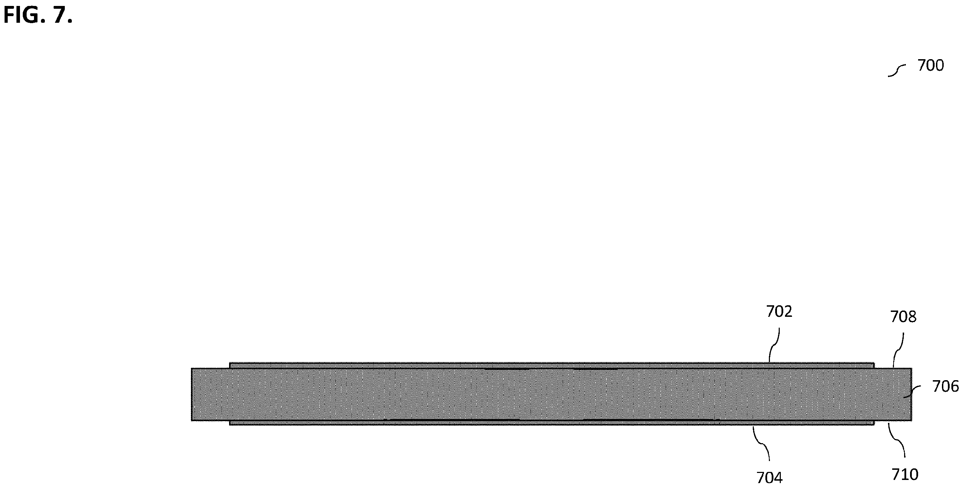

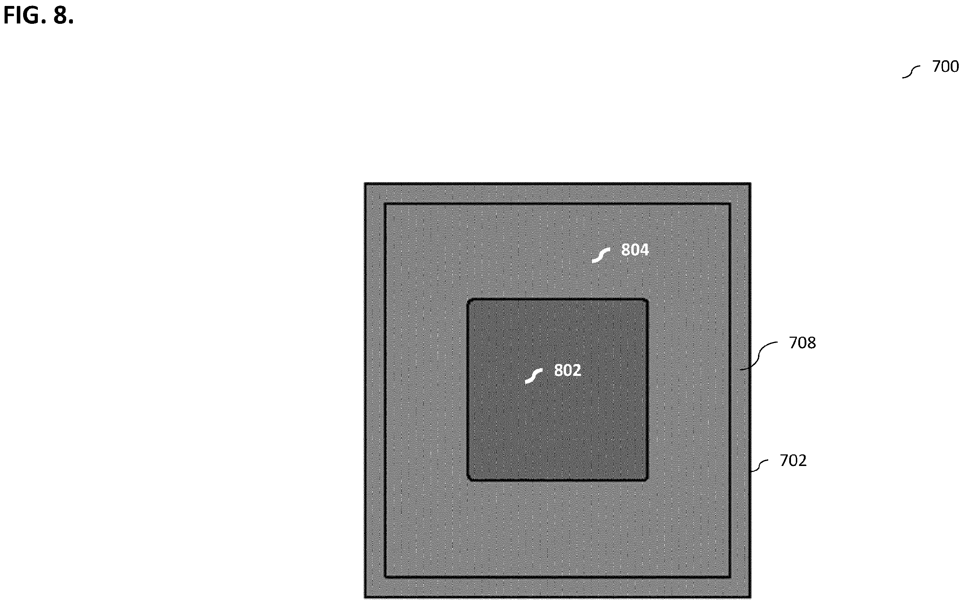

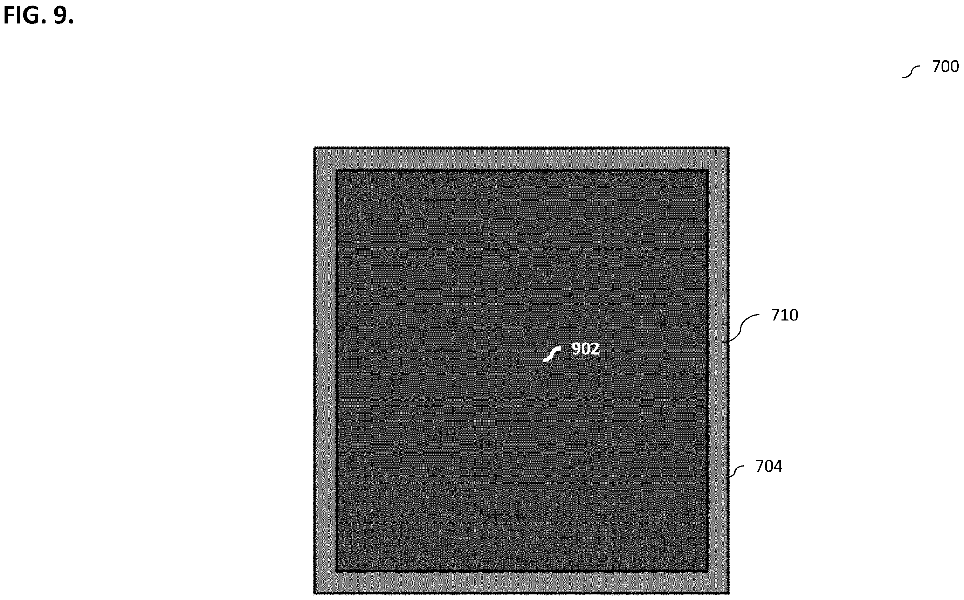

As stated above, transient voltage suppressor (TVS) semiconductor devices may be used to protect electronic components from transient voltages, overvoltage, etc. A TVS chip typically serves as a core part for a TVS semiconductor device. FIGS. 7-9 illustrate an existing TVS chip 700. In particular, FIG. 7 illustrates a side view of the TVS chip 700; FIG. 8 illustrates a top view of the TVS chip 700 shown in FIG. 7; and FIG. 9 illustrates a bottom view of the TVS chip 700 shown in FIG. 7.

Referring to FIG. 7, the TVS chip 700 may include a chip top portion 702, a chip bottom portion 704, a chip middle portion 706, a chip top protection ring 708, and a chip bottom protection ring 710. The chip middle portion 706 may be disposed between the chip top portion 702 and the chip bottom portion 704. The chip top protection ring 708 may be disposed proximate and/or may be coupled to the chip top portion 702. The chip bottom protection ring 710 may be disposed proximate and/or may be coupled to the chip bottom portion 704. The various couplings of components of the chip 700 may be accomplished in any desired way, such as, soldering, welding, etc.

The chip top portion 702, as shown in more detail in FIG. 8, may include a chip top working area 802, a chip top protection area 804, and the chip top protection ring 708. The chip top working area 802 may be enclosed by the chip protection area 804 and may be used for positioning and/or coupling of various electronic components associated with the chip 700. The chip protection area 804 may be further enclosed by the chip top protection ring 708.

The chip bottom portion 704, as shown in more detail in FIG. 9, may include a chip bottom working area 902 and the chip bottom protection ring 710. The chip bottom working area 902 may be enclosed by the chip bottom protection ring 710 and may be used for positioning and/or coupling of various electronic components associated with the chip 700.

The chip 700, as shown in FIGS. 7-9, may be used in various electronics applications, such as, for example, in the multi-point data transmission devices, systems, etc., where the chip 700 may be configured as an asymmetric TVS semiconductor device. Chip 700 may be used to protect against voltage transients that may be detrimental to operation of various electronic components.

Voltage transients are defined as short duration surges of electrical energy and are the result of the sudden release of energy previously stored and/or induced by other means, such as, for example, heavy inductive loads, lightning, etc. Voltage transients may be classified into predictable or repeatable transients and random transients. In electrical or electronic circuits, this energy can be released in a predictable manner via controlled switching actions, or randomly induced into a circuit from external sources. Repeatable transients are frequently caused by the operation of motors, generators, and/or the switching of reactive circuit components. On the other hand, random transients are often caused by electrostatic discharge (ESD) and lightning, which generally occur unpredictably.

ESD is characterized by very fast rise times and very high peak voltages and currents, which may be the result of an imbalance of positive and negative charges between objects. ESD that is generated by everyday activities can surpass a vulnerability threshold of standard semiconductor technologies. In case of lightning, even though a direct strike is destructive, voltage transients induced by lightning are not the result of a direct strike. When a lightning strike occurs, the event can generate a magnetic field, which, in turn, can induce voltage transients of large magnitude in nearby electrical cables. For example, a cloud-to-cloud strike will affect not only overhead cables, but also buried cables. Even a strike 1 mile distant (1.6km) can generate 70 volts in electrical cables. In a cloud-to-ground strike, the voltage transient generating effect is significantly greater.

Referring back to FIGS. 7-9, in some cases, TVS chips may be packaged using surface mounting (e.g., SMC) packaging, which provides for high power while having an overall small size. For example, SMC packaging may be used in printed circuit boards (PCBs) to protect various electronic components from ESD, electrical fast transients (EFT), lightning, and/or any other transients. SMC packaging allows for surface mounting of electronic components as well as optimization of the space on the PCB (on which such components may be mounted). It may further be characterized by a small profile, improved clamping capability, as well as other enhanced features.

Some asymmetric transient voltage suppressor devices may include special metallized working areas (e.g., working area 802 shown in FIG. 8, working area 902 shown in FIG. 9). Such asymmetric TVS chips may also have different heat dissipation and/or different manufacturing process features and/or requirements. In some implementations, the current subject matter relates to a surface mount (e.g., type A, type B, type C, etc.) packaging structure configured to address different heat dissipation and/or different manufacturing process features and/or requirements.

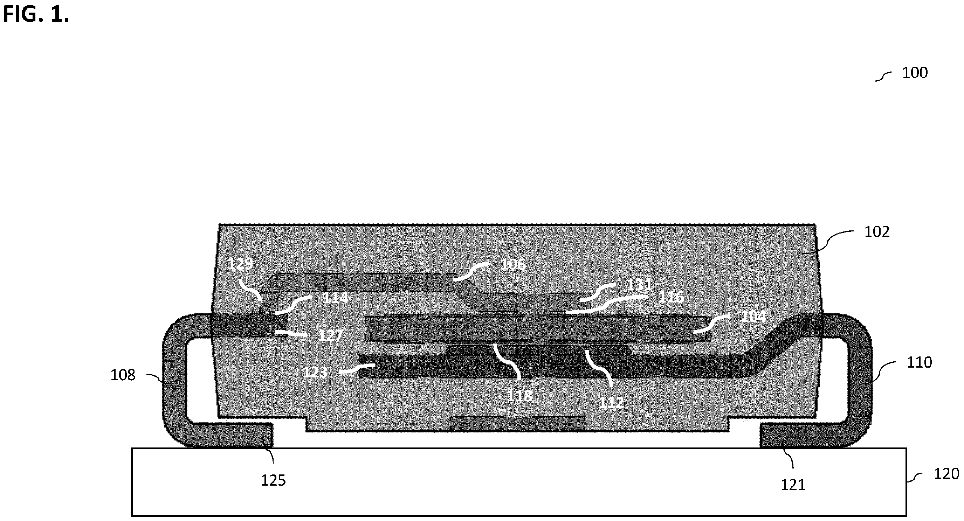

FIG. 1 illustrates an exemplary surface mount packaging structure 100, according to some implementations of the current subject matter. The structure 100 may include a housing or an encapsulation 102, a semiconductor and/or TVS chip 104, a clip 106, a first lead 108, a second lead 110, and a chip support or mounting (terms used interchangeably herein) pad 112 (which may be disposed on the second lead 110, as will be discussed below).

The housing 102 may be configured to house and/or encapsulate the chip 104, the clip 106, and at least portions of the first lead 108 and the second lead 110, including the chip support pad 112. The first lead 108 and the second lead 110 may be configured to extend from the housing 102 for conductively coupling to other electronic components and/or printed circuit board(s). The housing 102 may be configured to be manufactured from an epoxy compound, a plastic, and/or any other suitable material.

The first lead 108 may include a first end 125 and a second end 127. The first end 125 of the first lead 108 may be coupled to a substrate and/or printed circuit board (PCB) 120 and/or any other electronic component using any known mechanisms (e.g., solder, welding, etc.). The second end 127 may be coupled to the clip 106 using a conductive solder 114. In particular, the second end 127 of the first lead 108 may be coupled a first end 129 of the clip 106. While FIG. 1 illustrates the first lead 108 as having a curved shape, it can be understood, that the first lead 108 may have any desired shape and/or its shape may be changed to accommodate various circuit structures and/or positionings.

The second lead 110 may include a first end 121 and a second end 123. The first end 121 of the second lead 110 may be coupled to the PCB 120 and/or any other electronic component using any known mechanisms (e.g., solder, welding, etc.). The second lead 110 may also include the chip support pad 112 that may be disposed (e.g., soldered, welded, molded, etc.) proximate to the second end 123 of the second lead 110. The chip support pad 112 may also be coupled to the chip 104 using a conductive solder 118. Similarly, while FIG. 1 illustrates the second lead 110 as having a curved shape, it can be understood, that the second lead 110 may have any desired shape and/or its shape may be changed to accommodate various circuit structures and/or positionings.

In some implementations, the first and second leads 108, 110 may be manufactured from a conductive material, such as, for example, but not limited to, copper, copper alloy, silver, metallic alloys, etc., and/or any combinations thereof. The leads 108, 110 may be further configured to provide electrical connections between the TVS chip 104 and a circuit to which the structure 100 may be connected (e.g., PCB 120).

Moreover, in some example implementations, the first lead 108 and the second lead 110 may include various structural features (as will be discussed in further detail below) that may be configured to aid in manufacturing and usage processes of the structure 100. In particular, such structural features may reduce manufacturing stresses as well as reduce and/or prevent stress damage to the chip 104 during usage. For example, the first lead 108 may include a stress protection and/or relief bar (not shown in FIG. 1) and the second lead 110 may include a locking hole and a protection gap (not shown in FIG. 1) for these purposes.

In some example, non-limiting implementations, the first lead 108 may be configured as a cathode and the second lead 110 may be configured as an anode, such as, in a case of unidirectional TVS products. As can be understood, any other implementations of the leads 108 and 110 are possible.

The chip 104 (similar to the chip 700 shown in FIGS. 7-8) may be coupled to the clip 106. The coupling of the chip 104 and the clip 106 may occur within the housing 102. Moreover, chip 104's top working panel (e.g., working area 802 shown in FIG. 8) may be configured to be conductively coupled to a second end 131 of the clip 106 using a conductive solder 116. Further, chip 104's bottom working panel (e.g., working area 902 shown in FIG. 9) may be configured to be conductively coupled to the chip support pad 112 using conductive solder 118.

In some implementations, the clip 106 may be manufactured from a conductive material, such as, for example, but not limited to, copper, copper alloy, silver, metallic alloys, etc., and/or any combinations thereof. The clip 106 may be configured to provide an electrical path between the substrate 120, the chip 104, and the first and second leads 108, 110. The clip 106 may be configured to have a curved shape, a portion of which may be configured to extend away from the first lead 108 as well as the chip 104.

The clip 106 may be configured to absorb more solder during an assembly process of the structure 100 and may further enhance reliability of the structure 100 during operation. Moreover, clip 106 may include various structural features (e.g., heat dissipation panel and clip support process bars, as discussed in further detail below) that may be configured to improve and speed up heat dissipation during operation.

In some implementations, the chip support pad 112 disposed on the second lead 110 may be configured to have a larger surface area (as will be discussed below) that may be designed for coupling to a larger chip 104's bottom working panel (e.g., area 902 shown in FIG. 9). Such larger surface area of the chip support pad 112 may be configured to prevent solder overflow during assembly. Additionally, the chip support pad 112 may be advantageous in speeding up heat dissipation during operation of the structure 100.

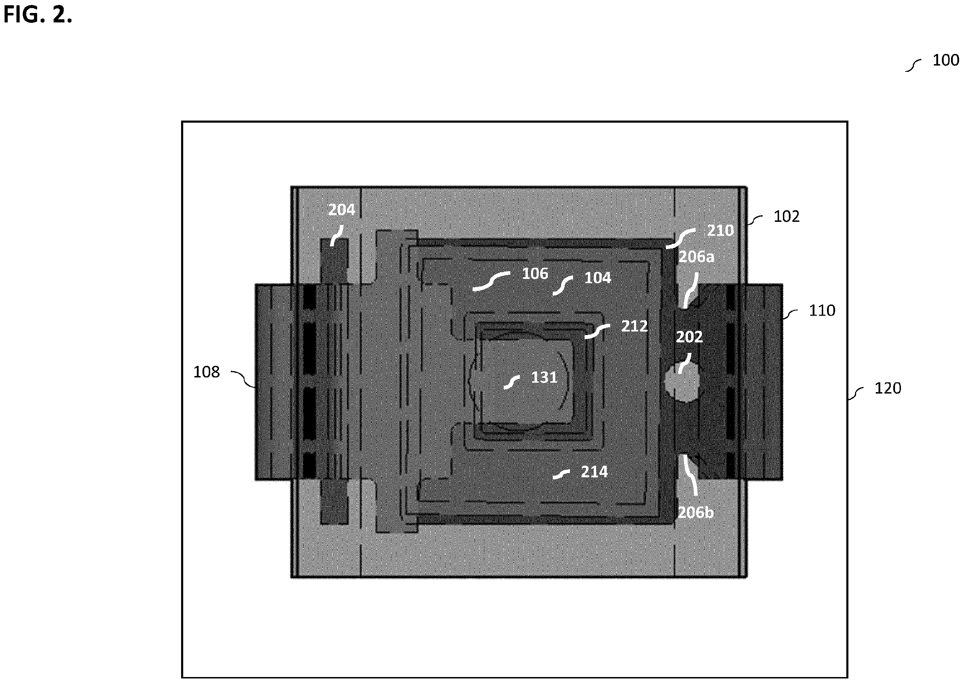

FIG. 2 illustrates a top view of the structure 100 shown in FIG. 1. As show in FIG. 2, the housing 102 may have a generally rectangular shape, but as can be understood, the housing 102 may have any desired shape. The chip 104 may be configured to be positioned on top of the second lead 110. A flat panel 210 of the second lead 110, above which, the chip 104 may be positioned, may be larger than the area of the chip 104.

The second end 131 of the clip 106 may be configured to be coupled to the working panel 212 of the chip 104. As shown in FIG. 2, the area of the second end 131 of the clip 106 may be smaller than the working panel 212 of the chip 104. The clip 106 may also be configured to extend above at least a portion of the protection panel 214 of the chip 104

The first lead 108 may include a stress protection/relief bar 204. The first end 129 of the clip 106 may be configured to be coupled to the stress protection/relief bar 204. The second lead 110 may include a stress protection/relief opening or hole 202 and one or more stress protection/relief grooves 206 (a, b). The stress protection/relief grooves 206 may be positioned on each side of the stress protection opening 202.

The stress protection opening 202 and stress protection/relief grooves 206 may be disposed proximal to the flat panel 210. The stress protection bar 204, the stress protection/relief opening 202 and the stress protection/relief grooves 206 may be arranged outside of a location where the chip 104 may be arranged. The stress protection/relief bar 204, the stress protection/relief opening 202 and the stress protection/relief grooves 206 may be configured to relieve some of the stress on the structure 100 during manufacturing and/or use, such as, for example, by providing more flexibility and heat dissipation capabilities to the structure 100, as well as reduce chip cracking, breakages, etc.

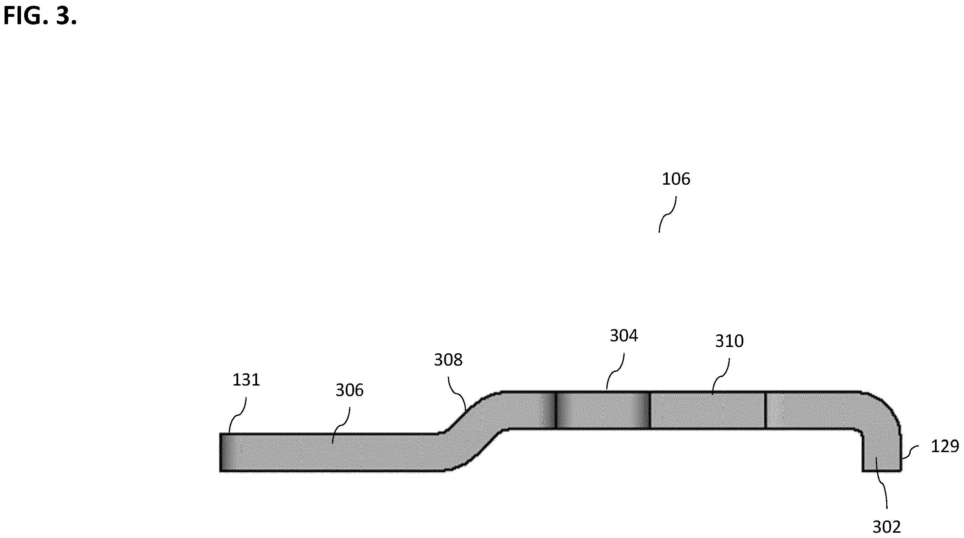

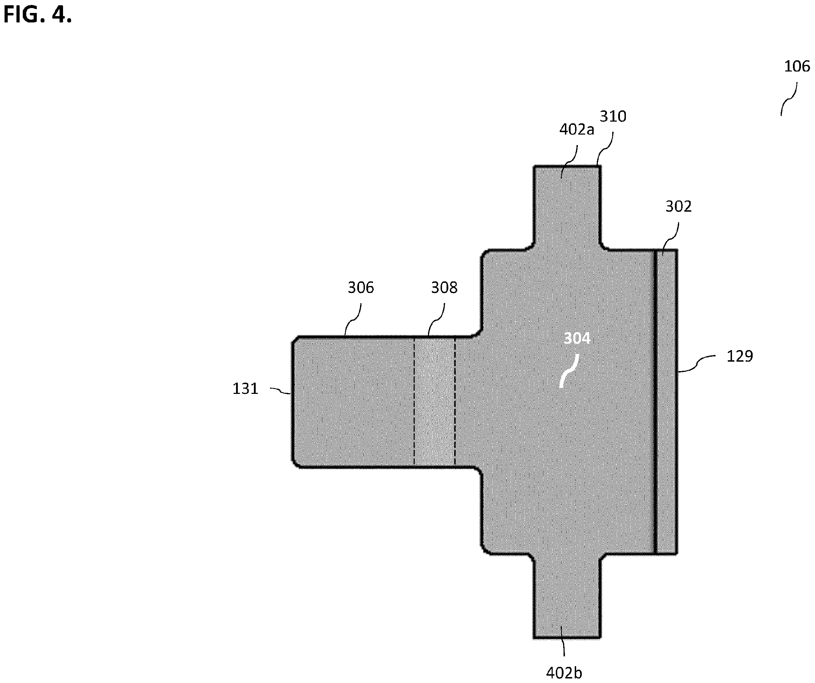

FIGS. 3-4 illustrate the clip 106 of the structure 100 shown in FIG. 1. In particular, FIG. 3 illustrates a side view of the clip 106 and FIG. 4 illustrates a top view of the clip 106.

As shown in FIG. 3, the clip 106 may include a first terminal 302 disposed at the first end 129 of the clip 106, a heat dissipation panel 304 having a support process bar 310, a bent portion 308, and a second terminal 306 disposed at the second end 131 of the clip 106. The first terminal 302 may include a curvature, where the terminal end 302 may be configured to curve in a direction away from the heat dissipation panel 304 of the clip 106.

The bent portion 308 may be disposed between the heat dissipation panel 304 and the second terminal 306. The bent portion 308 may also be configured to curve in a direction away from the heat dissipation panel 304 of the clip 106. However, the bent portion 308 may include a different angle of curvature than the curvature of the second terminal 306.

The second terminal 306 may be configured for coupling to the chip 104 (not shown in FIG. 3) using solder 116. The second terminal 306 may be configured to be substantially parallel to the heat dissipation panel 304 of the clip 106.

Referring to FIG. 4, illustrating a top view of the clip 106, the heat dissipation panel 304 may be configured to include support process bar portions 402(a, b) that may be configured to laterally extend away from the edges of the heat dissipation panel 304. The support process bar portions 402 (a, b) may be configured to form the support process bar 310, as shown in FIG. 3. In some example implementations, each portion 402 may be configured to extend perpendicularly away from each respective edge of the heat dissipation panel 304, and in opposite directions from one another. As can be understood, each portion 402 may be configured to extend in any desired direction.

As shown in FIG. 4, the second terminal 306 may be configured to have a smaller surface area than the surface area of the heat dissipation panel 304. The second terminal 306 may also be configured to extend perpendicularly away from the edge. The extension axis of the second terminal 306 may be configured to be perpendicular to the axis of extension of the portions 402. As can be understood, the second terminal 306 may be configured to extend in any desired direction.

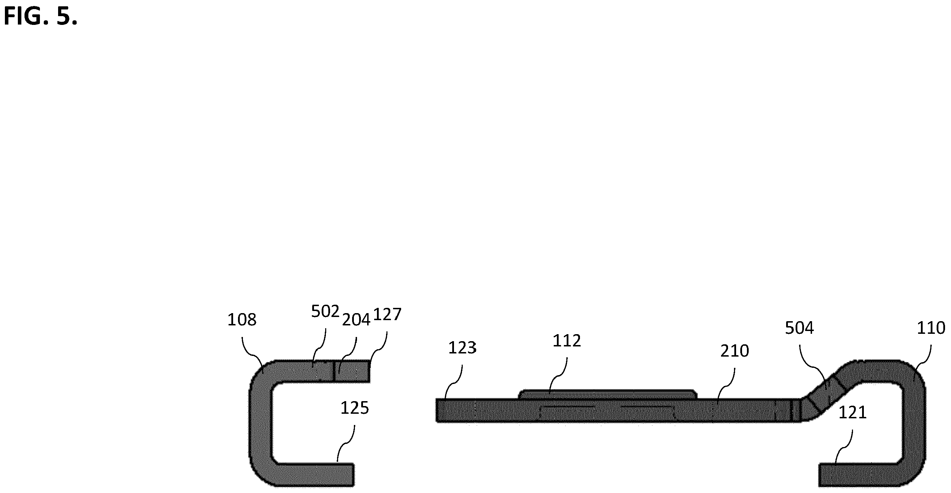

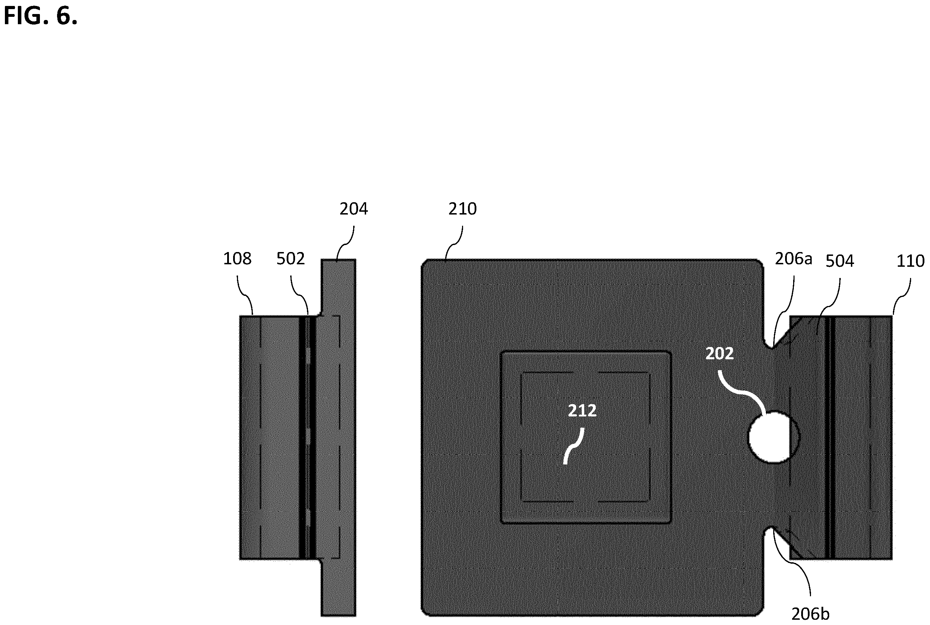

FIGS. 5-6 illustrate the first and second leads 108, 110 of the structure 100 shown in FIG. 1. In particular, FIG. 5 illustrates a side view of the first and second leads 108, 110 and FIG. 6 illustrates a top view of the first and second leads 108, 110.

As shown in FIG. 5, the first lead 108 may be configured to have a curved shape with the first end 125 being positioned for coupling with a substrate and/or PCB 120 (not shown in FIG. 5). The second end 127 may be positioned for coupling to the clip 106 (not shown in FIG. 5). The first lead 108 may also include a moisture proof groove and/or opening 502 that may be disposed proximal to the second end 127 of the first lead 108. The groove/opening 502 may be configured to reduce moisture content in the structure 100 during operation, manufacture, etc.

The second lead 110 may be configured to have a multi-curvature structure with its flat panel 210 extending between the second end 123 of the second lead 110 and a slanted portion 504. As discussed above, the flat panel 210 may be configured to include and/or be coupled to the chip support pad 112. The chip support pad 112 may be configured to be positioned on the side of the flat panel 210 that faces the chip 104 (not shown in FIG. 5). The chip support pad 112 may have a size/area that may be smaller than the area of the flat panel 210.

The slanted portion 504 may be configured to extend at an angle away from the flat panel 210 and toward the first end 121 of the second lead 110. The slanted portion 504 may be configured to house grooves 206 (a, b) and the stress protection/relief opening 202 (not shown in FIG. 5). The first end 121 may be similarly curved as the first lead 108. The curvature of the first end 121 may be configured for coupling to the substrate and/or PCB 120 (not shown in FIG. 5).

Referring to FIG. 6, the first lead 108 may include the stress protection/relief bar 204 that may be configured to extend laterally away from the body of the first lead 108. The length of the stress protection/relief bar 204 may be similar to the width of the flat panel 210, as show in FIG. 6. As can be understood, the stress protection/relief bar 204 may have any desired length, and may be selected in accordance with manufacturing, use, and/or any other requirements of the structure 100. As stated above, the stress protection/relief bar 204 may be used to reduce and/or alleviate stress that may be experienced by the structure 100 and/or its chip 104 during manufacturing and/or operation.

As shown for example in FIG. 6, the flat panel 210 of the second lead 110 may have a substantially rectangular shape (e.g., square), the dimensions of which may be selected to accommodate positioning of the chip 104 (not shown in FIG. 6) and/or any other components. For instance, the length and width of the flat panel 210 may be selected to be comparable to the length of the stress protection/relief bar 204. The chip support pad 112 may be positioned in a center of the flat panel 210 and/or in any other area. As can be understood, any desired shape, size, dimensions, etc. of the flat panel 210 and/or chip support pad 112 may be used.

As discussed above, the slanted portion 504 may be configured to include the stress protection/relief opening 202 and the grooves 206 (a, b), which may be disposed on either end of the opening 202. The grooves 206 may be configured to gradually reduce an overall width of the portion 504. The grooves 206 along with the opening 202 may be configured to provide further protection to the structure 100 and/or the chip 104 from stress, such as, during manufacturing, use, etc. One or more grooves 206 and/or one or more openings 202 may be used. Alternatively, or in addition, no grooves 206 and/or openings 202 may be included in the second lead 110.

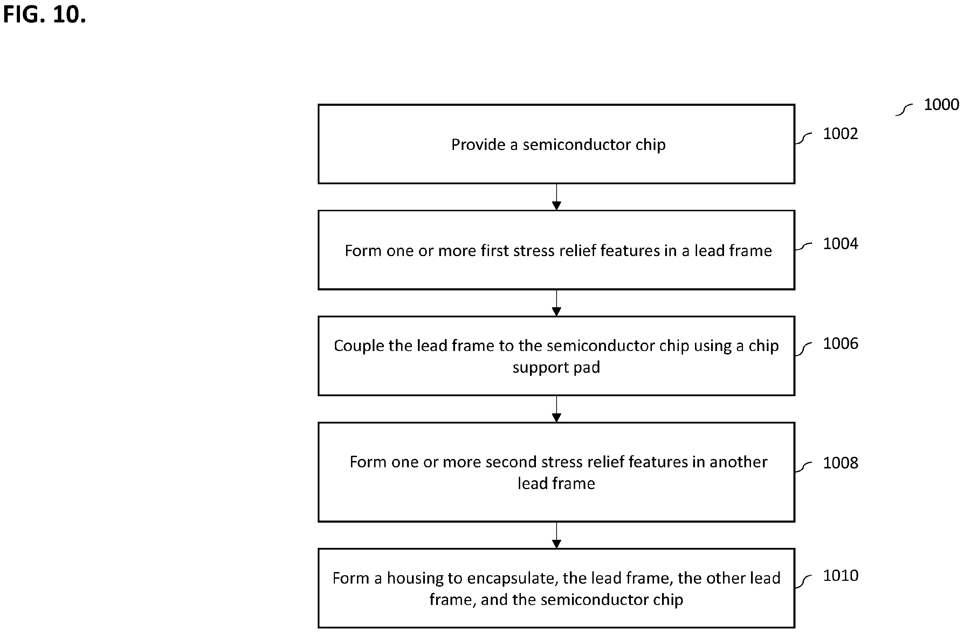

FIG. 10 illustrates an exemplary process 1000 for manufacturing and/or manufacturing a surface mounted packaging structure for asymmetric transient voltage suppressor devices, according to some implementations of the current subject matter. The process 1000 may be used for manufacturing and/or assembling the structure 100 shown and discussed above in connection with FIGS. 1-6. The process 1000 may be used for manufacturing/assembling any type of surface mounted structures, such as, for example, but not limited to, e.g., A type (SMA), B type (SMB), C type (SMC), etc.

At 1002, a semiconductor chip may be provided. For example, the semiconductor chip may be a power semiconductor chip, e.g., rated for 5000 W and/or greater, and/or any other type of chip. The semiconductor chip may have any desired shape, e.g., a rectangular, non-square shape, square shape, etc. An example of such chip is chip 104 shown in FIG. 1.

At 1004, one or more first stress relief features may be formed in a lead frame (or lead). For example, as shown in FIGS. 1-2, the lead frame may be the second lead 110. The lead frame may include a chip support or mounting (terms used interchangeably herein) pad (e.g., pad 212) disposed on a chip mounting surface (e.g., panel 210 as shown in FIGS. 2 and 6) of the lead frame. The first stress relief features may include one or more stress protection/relief opening(s) 202 and stress protection/relief groove(s) 206 (a, b) (as shown in FIGS. 2 and 6). The stress relief features may be formed outside of the chip mounting surface, e.g., panel 210.

At 1006, the lead frame (or a lead) may be coupled to the semiconductor chip. The semiconductor chip may be configured to be mounted on the chip support pad.

At 1008, one or more second stress relief features may be formed in another lead frame (or lead). Such other lead frame may be the first lead 108, as shown in FIGS. 1-6. The second stress relief features may include the stress protection/relief bar 204, as shown in FIGS. 2 and 6.

At 1010, a housing may be formed to encapsulate, the lead frame, the other lead frame, and the semiconductor chip, where at least a portion of each of the lead frames may be configured to extend outside of the housing.

The components and features of the devices described above may be implemented using any combination of discrete circuitry, application specific integrated circuits (ASICs), logic gates and/or single chip architectures. Further, the features of the devices may be implemented using microcontrollers, programmable logic arrays and/or microprocessors or any combination of the foregoing where suitably appropriate. It is noted that hardware, firmware and/or software elements may be collectively or individually referred to herein as "logic" or "circuit."

It will be appreciated that the exemplary devices shown in the block diagrams described above may represent one functionally descriptive example of many potential implementations. Accordingly, division, omission or inclusion of block functions depicted in the accompanying figures does not infer that the hardware components, circuits, software and/or elements for implementing these functions would necessarily be divided, omitted, or included in embodiments.

Some embodiments may be described using the expression "one embodiment" or "an embodiment" along with their derivatives. These terms mean that a particular feature, structure, or characteristic described in connection with the embodiment is included in at least one embodiment. The appearances of the phrase "in one embodiment" (or derivatives thereof) in various places in the specification are not necessarily all referring to the same embodiment. Moreover, unless otherwise noted the features described above are recognized to be usable together in any combination. Thus, any features discussed separately may be employed in combination with each other unless it is noted that the features are incompatible with each other.

It is emphasized that the abstract of the disclosure is provided to allow a reader to quickly ascertain the nature of the technical disclosure. It is submitted with the understanding that it will not be used to interpret or limit the scope or meaning of the claims. In addition, in the foregoing detailed description, it can be seen that various features are grouped together in a single embodiment for the purpose of streamlining the disclosure. This method of disclosure is not to be interpreted as reflecting an intention that the claimed embodiments require more features than are expressly recited in each claim. Rather, as the following claims reflect, inventive subject matter lies in less than all features of a single disclosed embodiment. Thus, the following claims are hereby incorporated into the detailed description, with each claim standing on its own as a separate embodiment. In the appended claims, the terms "including" and "in which" are used as the plain-English equivalents of the respective terms "comprising" and "wherein," respectively. Moreover, the terms "first," "second," "third," and so forth, are used merely as labels, and are not intended to impose numerical requirements on their objects. Further, the use of "including," "comprising," or "having" and variations thereof herein is meant to encompass the items listed thereafter and equivalents thereof as well as additional items. Accordingly, the terms "including," "comprising," or "having" and variations thereof are open-ended expressions and can be used interchangeably herein.

What has been described above includes examples of the disclosed architecture. It is, of course, not possible to describe every conceivable combination of components and/or methodologies, but one of ordinary skill in the art may recognize that many further combinations and permutations are possible. Accordingly, the novel architecture is intended to embrace all such alterations, modifications and variations that fall within the spirit and scope of the appended claims.

The foregoing description of example embodiments has been presented for the purposes of illustration and description. It is not intended to be exhaustive or to limit the present disclosure to the precise forms disclosed. Many modifications and variations are possible in light of this disclosure. It is intended that the scope of the present disclosure be limited not by this detailed description, but rather by the claims appended hereto. Future filed applications claiming priority to this application may claim the disclosed subject matter in a different manner and may generally include any set of one or more limitations as variously disclosed or otherwise demonstrated herein.

All directional references (e.g., proximal, distal, upper, lower, upward, downward, left, right, lateral, longitudinal, front, back, top, bottom, above, below, vertical, horizontal, radial, axial, clockwise, and counterclockwise) are just used for identification purposes to aid the reader's understanding of the present disclosure, and do not create limitations, particularly as to the position, orientation, or use of this disclosure. Connection references (e.g., attached, coupled, connected, and joined) are to be construed broadly and may include intermediate members between a collection of elements and relative movement between elements unless otherwise indicated. As such, connection references do not necessarily infer that two elements are directly connected and in fixed relation to each other.

Further, identification references (e.g., primary, secondary, first, second, third, fourth, etc.) are not intended to connote importance or priority but are used to distinguish one feature from another. The drawings are for purposes of illustration only and the dimensions, positions, order and relative sizes reflected in the drawings attached hereto may vary.

The present disclosure is not to be limited in scope by the specific implementations described herein. Indeed, other various implementations of and modifications to the present disclosure, in addition to those described herein, will be apparent to those of ordinary skill in the art from the foregoing description and accompanying drawings. Thus, such other implementations and modifications are intended to fall within the scope of the present disclosure. Furthermore, the present disclosure has been described herein in the context of a particular implementation in a particular environment for a particular purpose. Those of ordinary skill in the art will recognize the usefulness is not limited thereto and the present disclosure may be beneficially implemented in any number of environments for any number of purposes. Thus, the claims set forth below are to be construed in view of the full breadth and spirit of the present disclosure as described herein.

## Claims

1. An apparatus, comprising:
a housing;
a lead frame, at least partially encapsulated by the housing, the lead frame including a chip mounting surface having a chip mounting pad, and one or more first stress relief features disposed outside of the chip mounting surface; and
another lead frame, at least partially encapsulated by the housing, the another lead frame including one or more second stress relief features.

2. The apparatus according to claim 1, wherein a semiconductor chip is configured to be coupled to the chip mounting pad.

3. The apparatus according to claim 2, wherein, upon coupling of the semiconductor chip to the chip mounting pad, the chip mounting surface does not contact the semiconductor chip.

4. The apparatus according to claim 2 or 3, further comprising a clip fully encapsulated by the housing, wherein the another lead frame is configured to be coupled to the clip.

5. The apparatus according to any of the claims 2-4, wherein the semiconductor chip includes a semiconductor chip working area.

6. The apparatus according to claim 5, wherein the clip is configured to be coupled to the semiconductor chip working area.

7. The apparatus according to any of the claims 4-6, wherein the clip is configured to include one or more support bars extending laterally away from one or more edges of the clip.

8. The apparatus according to any of the preceding claims, wherein the one or more second stress relief features include one or more stress relief bars extending laterally away from the another lead frame.

9. The apparatus according to any of the claims 4-8, wherein the clip is configured to have a curved structure, wherein at least a portion of the curved structure of the clip is configured to extend away from the semiconductor chip.

10. The apparatus according to any of the preceding claims, wherein the lead frame includes a slanted portion configured to angularly extend away from the chip mounting surface, preferably wherein the one or more first stress relief features are configured to be formed in the slanted portion.

11. The apparatus according to any of the preceding claims, wherein the one or more first stress relief features include at least one of the following: a stress relief opening, one or more stress relief grooves, and any combination thereof, preferably
wherein the one or more stress relief grooves are configured to be formed symmetrically about the stress relief opening in the slanted portion of the lead frame.

12. The apparatus according to any of the preceding claims, where the lead frame includes a lead frame terminal end and the another lead frame includes another lead frame terminal end, preferably
wherein the lead frame terminal end and the another lead terminal frame end are configured to be coupled to at least one of the following: a substrate, a printed circuit board, and any combination thereof.

13. The apparatus according to any of the preceding claims with one or more of the following:
wherein the housing is manufactured from at least one of the following: an epoxy compound, a plastic, and any combination thereof;
wherein the apparatus is configured to be a surface mounted apparatus;
further comprising a transient voltage suppression device.

14. A method, comprising:
providing a semiconductor chip;
forming one or more first stress relief features in a lead frame, the lead frame is configured to include a chip mounting pad disposed on a chip mounting surface of the lead frame, the one or more first stress relief features are configured to be formed outside of the chip mounting surface;
coupling the lead frame to the semiconductor chip using the chip mounting pad;
forming one or more second stress relief features in another lead frame; and
forming a housing to encapsulate, the lead frame, the other lead frame, and the semiconductor chip, wherein at least a portion of each of the lead and the another lead frame is configured to extend outside of the housing, preferably
wherein the one or more first stress relief features include at least one of the following: one or more stress relief openings, one or more stress relief grooves, and any combination thereof; and
the one or more second stress relief features include one or more stress relief bars.

15. A packaging structure for asymmetric transient voltage suppressor, comprising:
a housing;
a lead frame, at least partially encapsulated by the housing, the lead frame including a chip mounting surface having a chip mounting pad, and one or more first stress relief features disposed outside of the chip mounting surface; and
another lead frame, at least partially encapsulated by the housing, the another lead frame including one or more second stress relief features.
